# EUROPEAN PATENT APPLICATION

(11) **EP 2 642 498 A2**
(43) Date of publication of application: **25.09.2013**
(21) Application number: 12178458.1
(22) Date of filing: 30.07.2012
(51) Int. Cl.: H01G 9/20, H01L 51/00

(54) **Photoelectric device**

(30) Priority: 17.07.2012 US 201213551561; 20.03.2012 US 201261613470 P
(71) Applicant: Samsung SDI Co., Ltd., Gyeonggi-do (KR)
(72) Inventor: Kim, Sung-Su, Gyeonggi-do (KR); Kim, Hyun-Chul, Gyeonggi-do (KR)
(74) Representative: Hewett, Jonathan Michael Richard

(57) **Abstract**

Provided is a photoelectric device including: first and second substrates disposed to face each other; a separator that is disposed between the first and second substrates, wherein a plurality of openings are formed in the separator such that first and second, opposite surfaces of the separator are fluidally connected to each other; and first and second electrodes that are respectively formed on the first and second surfaces of the separator. Accordingly, the costs for electrode materials and the manufacturing costs may be reduced, and also, resistive loss may be reduced.

## Description

The present invention relates to a photoelectric device.

Photoelectric devices which convert light energy to electric energy and solar cells using sun light to generate electric energy have drawn much attention as energy sources that can replace fossil fuel.

Solar cells using various driving principles have been studied, and dye sensitized solar cells having a very high photoelectric conversion efficiency compared to conventional solar cells are being noticed as next-generation solar cells.

The dye sensitized solar cells include a photosensitive dye that receives incident light having a wavelength of visible rays and generates excited electrons from the incident light, a semiconductor material capable of receiving the excited electrons, and an electrolyte reacting with electrons that returns electrons retrieved from an external circuit.

One or more embodiments of the present invention include a photoelectric device for which the costs for electrode materials and manufacturing costs may be reduced, and also, loss caused by electrical resistance (resistive loss) may be reduced.

According to one or more embodiments of the present invention, a photoelectric device includes: first and second substrates disposed to face each other; a separator that is disposed between the first and second substrates, wherein a plurality of openings are formed in the separator such that first and second, opposite surfaces of the separator are fluidally connected to each other; and first and second electrodes that are respectively formed on the first and second surfaces of the separator.

Openings that are fluidally connected to the openings of the separator may be formed in the first and second electrodes.

The openings of the first and second electrodes may be aligned with the openings of the separator.

The first and second electrodes may be formed of metal thin plates.

The first and second electrodes may include titanium.

The photoelectric device may further include: a light-absorbing layer formed on the first electrode; and a catalyst layer formed on the second electrode.

The light-absorbing layer may be formed on a surface of the first electrode facing the first substrate, and the catalyst layer is formed on a surface of the second electrode facing the second substrate.

Openings that are fluidally connected to the openings of the separator may be formed in the first and second electrodes, the light-absorbing layer, and the catalyst layer.

The openings may be formed by patterning the separator.

The openings may be formed of a plurality of pores formed in a porous separator.

An electrolyte may be filled between the first and second substrates, and the first and second substrates directly contact the electrolyte.

The separator may be formed of an insulating material so as to prevent a short circuit between the first and second electrodes.

The separator may be formed of a non-conductive resin material or a porous inorganic material.

The separator may be formed of polytetrafluoroethylene (PTFE) or a vinyl resin.

The separator may include a silicon (Si) oxide or a zirconium (Zr) oxide.

The photoelectric device may further include: a first spacer interposed between the first substrate and the separator; and a second spacer interposed between the second substrate and the separator.

The first and second spacers may respectively form first and second accommodation spaces, and the first and second accommodation spaces may be fluidally connected to each other.

The first and second spacers may be respectively formed on the first and second surfaces of the separator facing each other.

A plurality of first spacers may be formed on different positions of the first surface of the separator, and a plurality of second spacers may be formed on different positions of the second surface of the separator.

The separator may be spaced apart from the first and second substrates, wherein a plurality of the first and second spacers are interposed between the separator and the first and second substrates.

When the first substrate functions as a light-receiving surface for receiving incident light, the first spacer may be formed of a light transparent material.

The photoelectric device may further include a sealing member interposed between the first and second substrates.

As described above, according to the one or more of the above embodiments of the present invention, a light-absorbing layer is disposed in front of an electrode structure along a path of light, and thus an electrode may be formed using a metal having excellent electric conductivity without having to consider light transparency of the electrode structure. Accordingly, compared to a structure in which an electrode is formed of a transparent conducting layer having both optical transparency and electrical conductivity, the costs for materials and special processes may be reduced. In addition, by forming an electrode using a metal which has higher electric conductivity than a transparent conducting layer, resistance loss in a photocurrent may be reduced and a high photoelectric conversion efficiency may be obtained.
FIG. 1 is a disassembled perspective view of a photoelectric device according to an embodiment of the present invention;
FIG. 2 is a cross-sectional view of the photoelectric device of FIG. 1 cut along a line II-II;
FIG. 3 is an expanded view of a portion of the photoelectric device of FIG. 2;
FIG. 4 is a disassembled perspective view of a portion of the photoelectric device of FIG. 1;
FIGS. 5A through 5D are views for explaining formation of openings of a second electrode according to an embodiment of the present invention;
FIGS. 6A and 6B are views for explaining formation of openings of first and second electrodes and a separator according to an embodiment of the present invention;
FIG. 7 is a plan view of a separator according to another embodiment of the present invention;
FIG. 8 is a cross-sectional view of a photoelectric device according to a comparative example;
FIG. 9 is a disassembled perspective view of a photoelectric device according to another embodiment of the present invention;
FIG. 10 is a cross-sectional view of the photoelectric device cut along a line X-X of FIG. 9; and
FIG. 11 is an expanded view of a portion of the photoelectric device of FIG. 10.

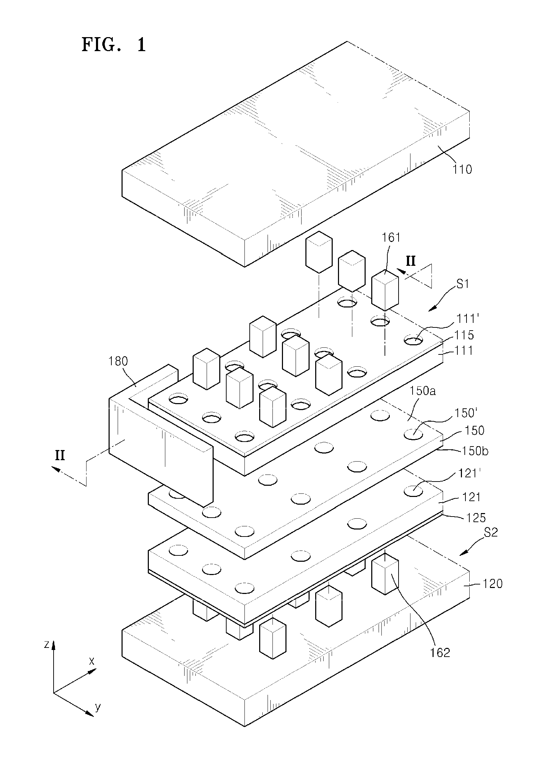

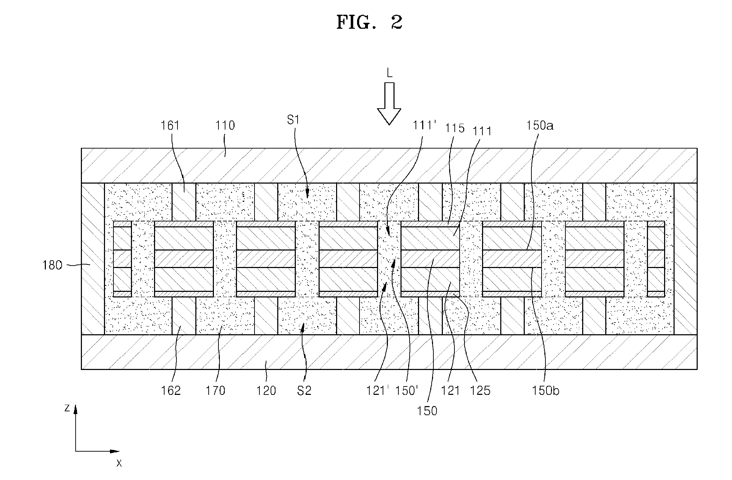

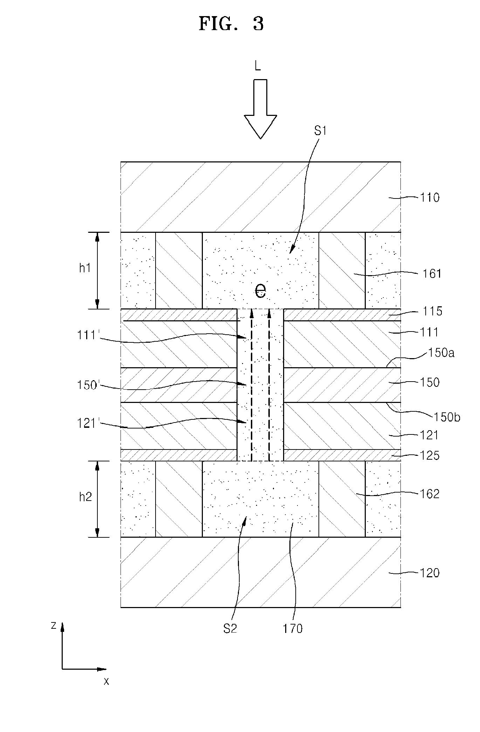

FIG. 1 is a disassembled perspective view of a photoelectric device according to an embodiment of the present invention. FIG. 2 is a cross-sectional view of the photoelectric device of FIG. 1 cut along a line II-II. FIG. 3 is an expanded view of a portion of the photoelectric device of FIG. 2.

Referring to FIGS. 1, 2, and 3, the photoelectric device includes: first and second substrates 110 and 120; a separator 150 that is disposed between the first and second substrates 110 and 120 and includes a plurality of openings 150' that are formed so that first and second surfaces 150a and 150b of the separator are fluidally connected to each to other; and first and second electrodes 111 and 121. In addition, a plurality of openings 111' and 121' that are fluidally connected to the openings 150' of the separator 150 may be formed in the first and second electrodes 111 and 121.

The first substrate 110 may be used as a light-receiving surface receiving incident light, and may be formed of a highly light-transmissive material. For example, the first substrate 110 may be formed of a glass substrate or a resin substrate. A resin substrate usually has flexibility, and is thus suitable for uses where flexibility is required.

The second substrate 120 is not limited as long as it may accommodate an electrolyte 170, and may be formed of a glass substrate or a resin substrate. The second substrate 120 may be disposed to face the first substrate 110 with the separator 150 interposed between the first substrate 110 and the second substrate 120. The second substrate 120 may be coupled to the first substrate 110 by using, for example, a sealing member 180. The sealing member 180 may be disposed along edges of the first and second substrates 110 and 120; that is, in this arrangement the sealing member 180 surrounds the electrolyte 170 filled between the first and second substrates 110 and 120 to encapsulate the photoelectric device, thereby protecting the photoelectric device from external environments. It is not, however, essential for the sealing member 180 to be positioned at the edges of the first and second substrates 110 and 120, and the sealing member 180 can be positioned inwardly from the substrate edges, so as to surround the electrolyte 170 filled between the first and second substrates.

As illustrated in FIGS. 2 and 3, the electrolyte 170 is filled between the first and second substrates 110 and 120, and the first and second substrate 110 and 120 may directly contact the electrolyte 170. As will be described above later, electrodes at two ends that form a current path of the photoelectric device, that is, first and second electrodes 111 and 121 are formed on the separator 150 but not on the first and second substrate 110 and 120. The first and second substrates 110 and 120 excluding the above-described electrode structure may directly contact the electrolyte 170.

The separator 150 physically separates the first and second electrodes 111 and 121 of opposite polarities and electrically insulates the first and second electrodes 111 and 121 from each other, thereby preventing an inner short circuit due to contact between the first and second electrodes 111 and 121. The separator 150 allows transportation of electrons e (see FIG. 3) according to an electrical field between the first and second electrodes 111 and 121, and transmission of the electrolyte 170, through which electrons e are transferred, or transmission of iodine ions in the electrolyte 170. The separator 150 may also be referred to as an electrochemical separator.

The separator 150 may be formed of an electrically insulating material, and may include a plurality of openings 150' so as to allow transmission of the electrolyte 170 or transmission of ions in the electrolyte 170. The first and second surfaces 150a and 150b of the separator 150 are fluidally connected to each other via the openings 150'. "The first and second surfaces 150a and 150b of the separator 150 being fluidally connected to each other" means that the electrolyte 170, through which electrons e are transferred, or ions in the electrolyte 170 (hereinafter "electrolyte 170") are able to pass through the separator 150, and that a current path may be formed through the separator 150 between the first electrode 111 and the second electrode 121.

The separator 150 may be formed of a material that has electrical insulation properties and has little reactivity with respect to the electrolyte 170 in a high-temperature operating environment reaching 85 degrees and has a stable chemical stability with respect to the electrolyte 170. In detail, the separator 150 may be formed of a non-conductive resin material such as polytetrafluoroethylene (PTFE) or a vinyl resin.

The openings 150' of the separator 150 may be formed by processing a planar raw material by perforation such as punching or stamping or by molding of a resin material. For example, the separator 150 may be formed of a non-conductive resin material, and a plurality of openings 150' may be formed by molding a non-conductive resin material.

As long as the openings 150' of the separator 150 are fluidally connected, the forms of the openings 150' are not limited. As illustrated in FIG. 1, the openings 150' may be patterned in the separator 150. For example, the openings 150' may be formed by patterning generally at uniform positions, and as illustrated in FIG. 1, the openings 150' may be arranged in matrix patterns along a row direction (x-direction) and a column direction (y-direction).

When forming patterns of the openings 150', the openings 150' may be distributed over the entire surface area of the separator 150 with a uniform density so that the electrolyte 170, through which electrons are transported, may be uniformly transmitted. In an area with a low degree of transmission of the electrolyte 170, a path resistance of electron transportation increases and thus photoelectric efficiency is decreased, and thus the openings 150' may be distributed over the entire area of the separator 150 at a uniform density.

The forms of the openings 150' may be variously formed in consideration of flow resistance of the electrolyte 170, workability in regard to perforation, and mechanical intensity of the separator 150, and as illustrated in FIG. 1, the openings 150' may have an approximately circular shape, or a polygonal shape such as a square.

The first and second electrodes 111 and 121 having opposite polarities are arranged on the first and second surfaces 150a and 150b of the separator 150, respectively. The first and second electrodes 111 and 121 may be disposed to face each other by interposing the separator 150 therebetween, and may have planar shapes over the entire surface areas of the first and second surfaces 150a and 150b of the separator 150.

The first electrode 111 may be formed as a negative electrode of the photoelectric device, for example, as a negative electrode that withdraws light-generated carriers such as electrons. The second electrode 121 may be formed as an electrode of the opposite polarity to the first electrode 111, for example, as a positive electrode, and may accommodate, for example, a flow of electrons that have passed through an external circuit (not shown) and supply the same to the first electrode 111.

The first and second electrodes 111 and 121 may be formed of a metal having excellent electrical conductivity, and may be formed of a metal that has little reactivity with respect to the electrolyte 170 in a high-temperature operating environment reaching about 85°C and has a stable chemical stability with respect to the electrolyte 170, for example, titanium. For example, the first and second electrodes 111 and 121 may be formed of a thin film plate covering the entire surface area of the first and second surfaces 150a and 150b such as a titanium thin film plate.

A light-absorbing layer 115 may be formed on the first electrode 111. The light-absorbing layer 115 may be electrically connected to the first electrode 111, and may form a conductive contact with the first electrode 111. The light-absorbing layer 115 may absorb light L incident through the first substrate 110 to generate light carriers, for example, electrons. The light-absorbing layer 115 may be formed on a surface of the first electrode 111 facing the first substrate 110 so as to absorb as much light L as possible.

For example, the light-absorbing layer 115 may include a semiconductor layer to which a photosensitive dye is adsorbed. For example, the semiconductor layer may be formed of an oxide of a metal such as Cd, Zn, In, Pb, Mo, W, Sb, Ti, Ag, Mn, Sn, Zr, Sr, Ga, Si, or Cr.

For example, the photosensitive dye may be formed of molecules that are absorbed in a visible ray band and cause fast electron transportation from a light-excited state to a semiconductor layer. For example, the photosensitive dye may be a ruthenium-based photosensitive dye.

A catalyst layer 125 may be formed on the second electrode 121. The catalyst 125 may be electrically connected to the second electrode 121, and may form a conductive contact with the second electrode 121. For example, the catalyst layer 125 may function as a reduction catalyst with respect to the electrolyte 170. For example, the catalyst layer 125 may function as a reduction catalyst receiving electrons provided via the second electrode 121 and reducing the electrolyte 170, and may ultimately reduce the light-absorbing layer 115 which is oxidized according to withdrawal of light-generated electrons, again. For example, the catalyst layer 125 may be formed on a surface of the second electrode 121 facing the second substrate 120 so as to form a broad contact surface with the electrolyte 170.

The catalyst layer 125 may be formed of a material having a catalyzed reduction function for providing electrons to the electrolyte 170, and may be formed of, for example, a metal such as platinum (Pt), gold (Ag), silver (Au), copper (Cu), aluminium (Al), a metal oxide such as a tin oxide, or a carbonaceous material such as graphite.

In order to allow transmission of the electrolyte 170, a plurality of openings 111' and 121' may be formed in the first and second electrodes 111 and 121, and the openings 111' and 121' of the first and second electrodes 111 and 121 may be fluidally connected to the openings 150' of the separator 150, thereby forming a path of the electrolyte 170 through which electrons are transported.

Referring to FIG. 1, a plurality of openings 111' may be formed in the first electrode 111 and the light-absorbing layer 115 formed on the first surface 150a of the separator 150 so as to allow transmission of the electrolyte 170. For example, the openings 111' of the first electrode 111 and the light-absorbing layer 115 may be aligned. While the openings 111' of the first electrode 111 and the light-absorbing layer 115 are denoted by the same reference numeral, this is for convenience of understanding, and the openings 111' of the first electrodes 111 and the light-absorbing layer 115 are not necessarily aligned.

Similarly, a plurality of openings 121' may be formed in the second electrode 121 and the catalyst layer 125 formed on the second surface 150b of the separator 150 so as to allow transmission of the electrode 170. For example, the openings 121' of the first electrode 121 and the catalyst layer 125 may be aligned. While the openings 121' of the first electrode 121 and the catalyst layer 125 are denoted by the same reference numeral, this is for convenience of understanding, and the openings 121' of the first electrodes 121 and the catalyst layer 125 are not necessarily aligned in position.

The openings 111' and 121' of the first and second electrodes 111 and 121 may form a path of the electrolyte 170 connected to the openings 150' of the separator 150. By forming a path of the electrode layer 170 that is fluidally connected from the catalyst layer 125 to the light-absorbing layer 115 in a thickness direction of the separator 150, a path for reduction electrons may be formed from the catalyst layer 125 to the light-absorbing layer 115 by the medium of the electrolyte 170.

According to the embodiment of FIG. 1, the openings 150' of the separator 150 and the openings 111' and 121' of the first and second electrodes 111 and 121 are aligned with each other, and are continuously extended in a thickness direction, but are not limited thereto. For example, the openings 150' of the separator 150 and the openings 111' and 121' of the first and second electrodes 111 and 121 may be offset from each other as long as they are fluidally connected to each other to form a path of the electrolyte 170.

A first spacer 161 is interposed between the first substrate 110 and the separator 150. The first spacer 161 may form a first accommodation space S1 between the first substrate 110 and the separator 150. Also, a second spacer 162 is interposed between the second substrate 120 and the separator 150. The second spacer 162 may form a second accommodation space S2 between the second substrate 120 and the separator 150. The first and second accommodation spaces S1 and S2 are fluidally connected to each other via the openings 111', 150', and 121' of the separator 150 and the first and second electrodes 111 and 121.

The first and second accommodation spaces S1 and S2 and the openings 111', 150', and 121' connecting these are filled with the electrolyte 170, and a current path between the first electrode 111 (or the light-absorbing layer 115) in the first accommodation space S1 and the second electrode 121 (or the catalyst layer 125) in the second accommodation space S2 may be formed via the electrolyte 170.

Referring to FIG. 3, heights h1 and h2 of the first and second spacers 161 and 162 are directly linked to a volume of the first accommodation space S1 between the first substrate 110 and the separator 150 and a volume of the second accommodation space S2 between the second substrate 120 and the separator 150. For example, by adjusting the heights h1 and h2 of the first and second spacers 161 and 162, volumes of the first and second accommodation spaces S1 and S2 may be controlled, and the amount of the electrolyte 170 stored in the first and second accommodation spaces S1 and S2 may be increased or decreased. According to the current embodiment, the heights h1 and h2 of the first and second spacers 161 and 162 may be approximately the same but are not limited thereto.

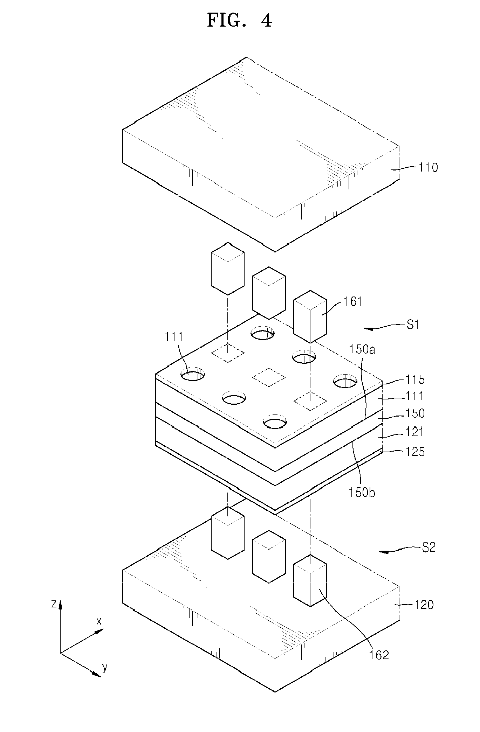

FIG. 4 is a disassembled perspective view of a portion of the photoelectric device of FIG. 1. Referring to FIG. 4, the separator 150 interposed between the first and second substrates 110 and 120 are spaced apart from the first and second substrate 110 and 120. The separator 150 may be respectively supported by the first and second spacers 161 and 162 via different surfaces, that is, the first and second surfaces 150a and 150b. In order to firmly fix the separator 150 and also to maintain the first and second accommodation spaces S1 and S2 at uniform intervals, a plurality of the first and second spacers 161 and 162 may be included. For example, the first and second spacers 161 and 162 may be disposed to face each other by interposing the separator 150 therebetween.

A plurality of first spacers 161 may be disposed on different positions between the first substrate 110 and the light-absorbing layer 115, and a plurality of second spacers 162 may be disposed on different positions between the second substrate 120 and the catalyst layer 125.

The arrangement, number, and shape of the first and second spacers 161 and 162 are not as illustrated in FIG. 4 but may be various as long as they respectively form the first and second accommodation spaces S1 and S2 between the first and second substrates 110 and 120 and the separator 150. For example, referring to FIG. 4, the first and second spacers 161 and 162 have column forms that are individually isolated, but alternatively, the first and second spacers 161 and 162 may be striped patterned spacers extended in a predetermined direction or sheet-type spacers in a mesh pattern.

The first spacer 161 may be formed between the first substrate 110 and the light-absorbing layer 115. When the first spacer 161 is formed of a material having a high light transmittivity, light loss of the light absorption layer 115 may be reduced, and thus, the first spacer 161 may be formed of glass frit or a transparent resin material.

The first and second spacers 161 and 162 may be formed of a material that may be adhered between the first and second substrates 110 and 120 and the separator 150 according to heat curing, laser irradiation, or the like; for example, the first and second spacers 161 and 162 may be formed of a glass frit, an organic resin, or a hot melt resin.

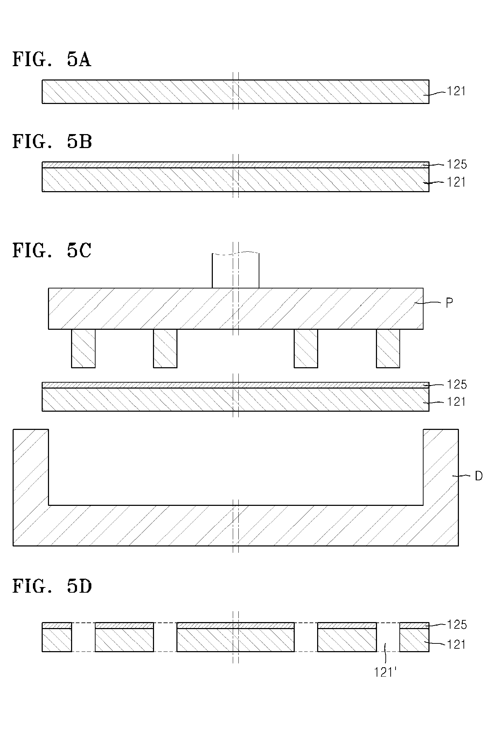

FIGS. 5A through 5D are views for explaining formation of the openings 121' of the second electrode 121 according to an embodiment of the present invention. As illustrated in FIGS. 5A and 5B, the catalyst layer 125 is stacked on the second electrode 121 to form a raw material substrate. For example, a layer forming process such as sputtering or printing may be applied on the second electrode 121 to form the catalyst layer 125.

Next, as illustrated in FIGS. 5C and 5D, the raw material substrate is perforated to form a plurality of openings 121'. For perforation of the raw material substrate, punching or stamping may be applied.

For example, the raw material substrate may be placed on a worktable D and pressurized using a press P to thereby perforate the catalyst layer 125 and the second electrode 121, and the openings 121' of the catalyst layer 125 and the second electrode 121 may be aligned.

Meanwhile, similarly to FIGS. 5A through 5D, the same operations may be used to form the openings 111' of the first electrode 111. That is, the light-absorbing layer 115 may be stacked on the first electrode 111 to form a raw material substrate, and the raw material substrate may be perforated to perforate the light-absorbing layer 115 and the first electrode 111, and the openings 111' of the light-absorbing layer 115 and the first electrode 111 ay be aligned.

However, the embodiments of the present invention are not limited thereto, and for example, the first electrode 111 may be perforated to form a plurality of openings 111', and then the light-absorbing layer 115 may be patterned to correspond to patterns of the openings 111' of the first electrode 111.

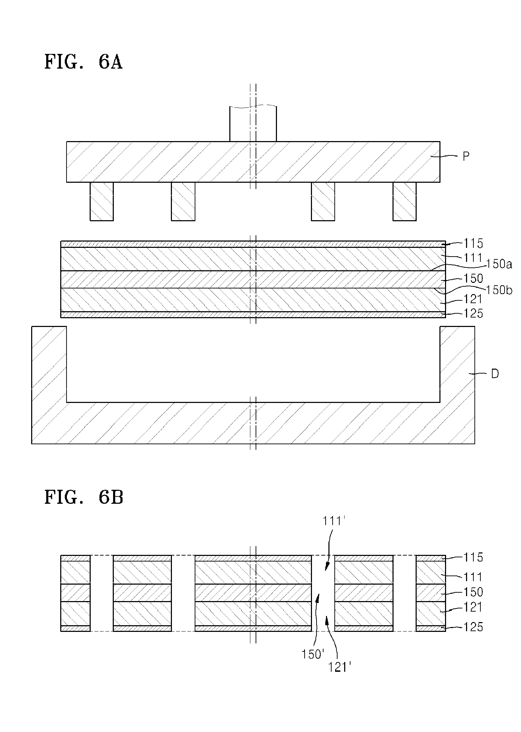

FIGS. 6A and 6B are views for explaining formation of the openings 111', 150', and 121' of the separator 150 and the first and second electrodes 111 and 121 according to an embodiment of the present invention. Referring to FIGS. 6A and 6B, the first electrode 111 and the light-absorbing layer 115 are stacked on the first surface 150a of the separator 150, and the second electrode 121 and the catalyst layer 125 are stacked on the second surface 150b of the separator 150, thereby forming a raw material substrate. Then, the raw material substrate may be perforated. For perforation of the raw material substrate, punching or stamping may be applied.

For example, the raw material substrate may be placed on a worktable D and pressurized using a press P to thereby perforate the first and second electrodes 111 and 121 and the separator 150, and the openings 111', 150', and 121' of the first and second electrodes 111 and 121 and the separator 150may be aligned.

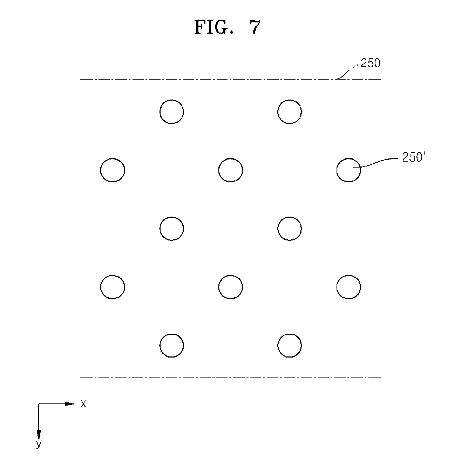

FIG.7 is a plan view of a separator 250 according to another embodiment of the present invention. Referring to FIG. 7, a plurality of openings 250' are arranged in the separator 250 in alternate patterns; for example, a row of openings 250' may be arranged in alternating positions with respect to an adjacent row of openings 250'. According to this pattern of the openings 250', transmission of the electrolyte 170 may be uniformly conducted over the entire area of the separator 250. Alternatively, the openings 250' of the separator 250 may be arranged, for example, on irregular positions instead of at regular positions and in regular patterns.

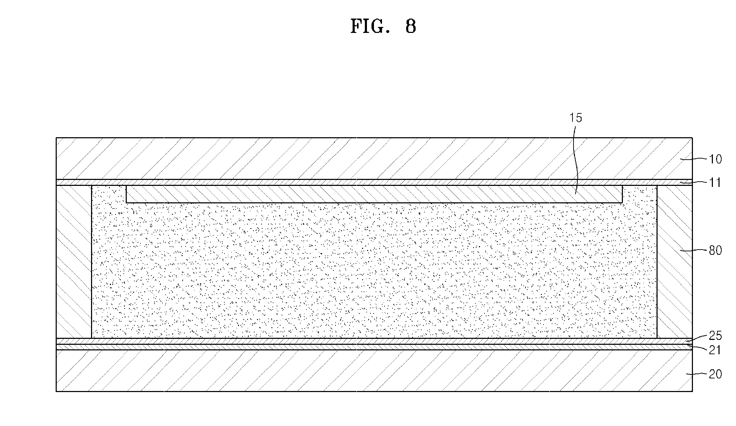

FIG. 8 is a cross-sectional view of a photoelectric device according to a comparative example, not falling within the scope of the claims. Referring to FIG. 8, the photoelectric device includes first and second substrate 10 and 20 and first and second electrodes 11 and 21 respectively formed on the first and second substrate 10 and 20. The photoelectric device includes a light-absorbing layer 15 formed on the first electrode 11 and a catalyst layer 25 formed on the second electrode 21.

Light that has transmitted through the first electrode 11 is absorbed by the light-absorbing layer 15, and electrons are generated through excitation of the light-absorbing layer 15. The first electrode 11 is formed of a material having electrical conductivity and also optical transparency so as to allow light transmission. In detail, the first electrode 11 may be formed of a transparent conducting oxide (TCO) such as indium tin oxide (ITO), fluorine tin oxide (FTO), or antimony tin oxide (ATO). To form a transparent conductive layer, expensive materials and special layer forming processes are required, and this increases the manufacturing costs of the photoelectric device. In addition, due to the characteristics of the material of the transparent conductive layer, the transparent conductive layer has low electrical conductivity, which increases electrical resistance of a photocurrent.

Meanwhile, the second electrode 21 is formed on the second substrate 20, and in consideration of adhering characteristics with respect to the second substrate 20 which is a glass substrate, the second electrode 21 is also formed of a transparent conductive layer. As a result, according to the comparative example, transparent conductive layers are used to a wide extent as the first and second electrodes 11 and 21, and thus the manufacturing costs are increased, and due to the decreased conductive characteristics compared to metals, resistance loss is generated.

According to the embodiment of FIG. 1, the light-absorbing layer 115 is formed in front of the first electrode 111 along a direction of light incidence, and thus the first electrode 111 may be formed of a metal which is opaque. That is, as the first electrode 111 and the light-absorbing layer 115 are sequentially formed on the separator 150, the first electrode 111 may be excluded from a path of incidence of the light-absorbing layer 115, and the first electrode 111 may be formed of a metal which is opaque. By forming the first electrode 111 using a metal instead of a transparent conductive layer, the manufacturing costs of the photoelectric device may be reduced, and resistive loss may also be reduced.

The second electrode 121 is formed on the second surface 150b of the separator 150, and thus there is no need to consider adhering characteristics of the second electrode 121 with the second substrate 120. Accordingly, the second electrode 121 may be formed of a metal having excellent electrical conductivity. By forming the second electrode 121 using a metal instead of a transparent conductive layer, the manufacturing costs of the photoelectric device may be reduced, and resistive loss may also be reduced.

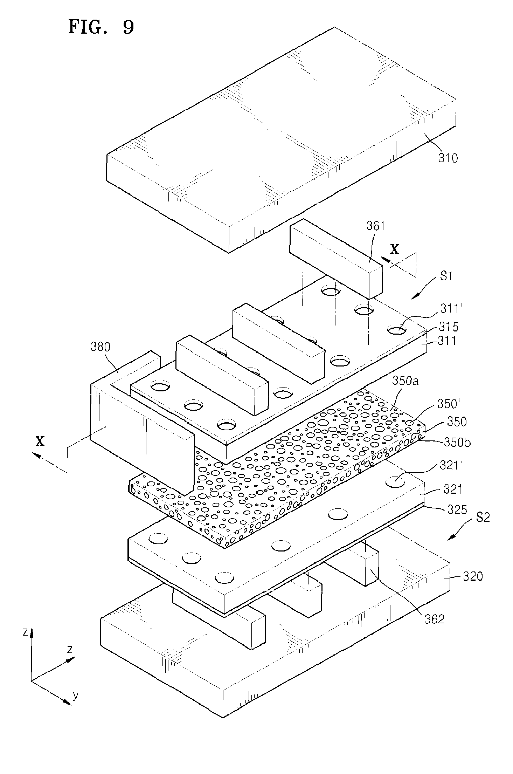

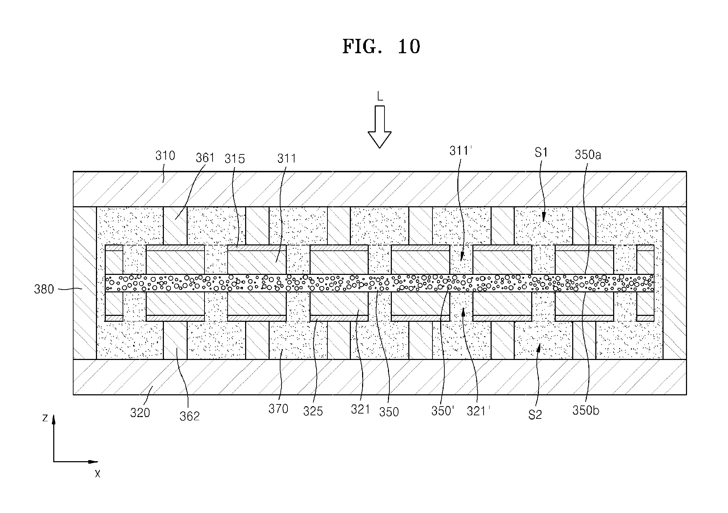

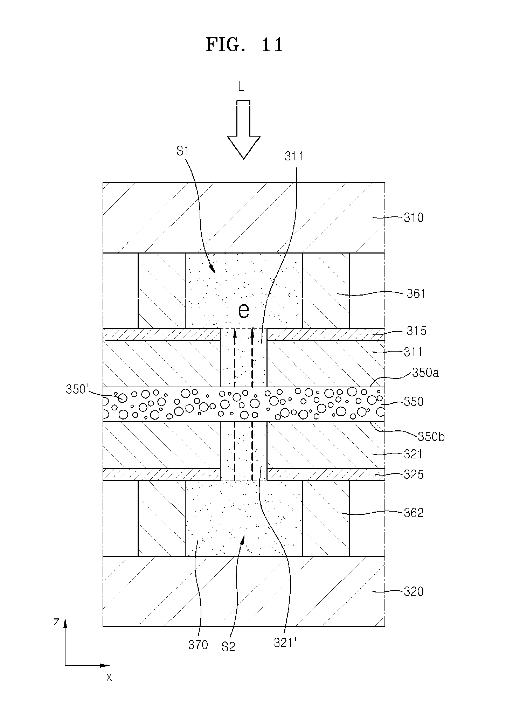

FIG. 9 is a disassembled perspective view of a photoelectric device according to another embodiment of the present invention. FIG. 10 is a cross-sectional view of the photoelectric device cut along a line X-X of FIG. 9. FIG. 11 is an expanded view of a portion of the photoelectric device cut along of FIG. 10.

Referring to FIGS. 9 through 11, the photoelectric device includes first and second substrates 310 and 320 facing each other, and a separator 350 that is disposed between the first and second substrates 310 and 320 and includes a plurality of openings 350' that are formed so that first and second, opposite surfaces 350a and 350b are fluidally connected. In addition, the photoelectric device includes first and second electrodes 311 and 321 that are formed on the first and second surfaces 350a and 350b of the separator 350, respectively.

The separator 350 physically separates the first and second electrodes 311 and 321 of different polarities and electrically insulates the first and second electrodes 311 and 321 from each other, thereby preventing an inner short circuit due to contact between the first and second electrodes 311 and 321. The separator 350 allows transportation of electrons e according to an electrical field between the first and second electrodes 311 and 321, and, for example, transmission of the electrolyte 370, through which electrons e are transferred.

The separator 350 may be formed of an electrical insulation material, and may have a porous structure in which a plurality of openings 350' are formed so that the electrolyte 370 may transmit through. For example, the separator 350 may be formed of a porous inorganic material.

When the separator 350 has a porous structure, in this porous structure, a plurality of openings 350' arranged on a two-dimensional plane or a plurality of openings 350' arranged three-dimensionally are included. For example, the separator 350 may include a silicon (Si) oxide or a zirconium (Zr) oxide; in detail, the separator 350 may have a structure in which a plurality of oxide particles are adhered to one another while having pores interposed therebetween, or the separator 350 may be an inorganic thin layer that is formed on a sponge-shaped carrier substrate (not shown) including a plurality of pores. The pores between the plurality of oxide particles or the pores of the carrier substrate correspond to the openings 350' that allow transmission of the electrolyte 370. Also, the separator 350 may be formed as a membrane in which a plurality of pores are arranged two-dimensionally, and the plurality of pores correspond to the openings 350' that allow transmission of the electrolyte 370.

When the separator 350 has a porous structure, this porous structure includes openings 350' of both relatively fine scales and coarse scales. For example, the porous structure of the separator 350 may be formed by performing a mechanical forming operation such as punching or stamping to a planar raw material or various porous processes such as sintering of micro-scale particles.

The first and second electrodes 311 and 321 of opposite polarities are formed on the first and second surfaces 350a and 350b of the separator 350, respectively. The first and second electrodes 311 and 321 may be formed of a metal having excellent electrical conductivity, and may be formed as a metal thin plate over the entire surface areas on the first and second surfaces 350a and 350b. In detail, the first and second electrodes 311 and 321 may include titanium thin plates.

According to the current embodiment of the present invention, as the first and second electrodes 311 and 321 are formed of a metal, the costs for transparent conductive layers may be reduced, and resistive loss due to the first and second electrodes 311 and 321 may be reduced. In detail, by disposing a light-absorbing layer 315 in front of the first electrode 311 in a direction of incidence of light (L), optical transparency of the first electrode 311 is not to be considered. Accordingly, the first electrode 311 may be formed of a metal instead of a transparent conductive layer, thereby reducing resistive loss.

The light-absorbing layer 315 may be formed on the first electrode 311. The light-absorbing layer 315 may be formed on a surface of the first electrode 311 facing the first substrate 310 so that as much light L as possible may be absorbed by the light-absorbing layer 315. A catalyst layer 325 may be formed on the second electrode 320. In order to form a broad contact surface area with the electrolyte 370, the catalyst layer 325 may be formed on a surface of the second electrode 321 facing the second substrate 320.

A plurality of openings 311' and 321' may be formed in the first and second electrodes 311 and 321 so as to allow transmission of the electrolyte 370, and the openings 311' and 321' of the first and second electrodes 311 and 321 may be fluidally connected to the openings 350' of the separator 350 to form a path of the electrolyte 370, through which electrons (e) are transported. By forming a path of the electrode layer 370 that is fluidally connected from the catalyst layer 325 to the light-absorbing layer 315 in a thickness direction of the separator 350, transportation of electrons (e) may be conducted through the electrolyte 370.

A first spacer 361 is interposed between the first substrate 310 and the separator 350. The first spacer 361 may form a first accommodation space S1 between the first substrate 310 and the separator 350. Also, a second spacer 362 is interposed between the second substrate 320 and the separator 350. The second spacer 362 may form a second accommodation space S2 between the second substrate 320 and the separator 350. The first and second accommodation spaces S1 and S2 are fluidally connected to each other via the openings 311', 350', and 321' of the separator 350 and the first and second electrodes 311 and 321.

The first and second spacers 361 and 362 may support the separator 350 via the different, first and second surfaces 350a and 350b, and may fix the separator 350 away from the first and second substrates 310 and 320. In order to firmly fix the separator 350 and also to maintain the first and second accommodation spaces S1 and S2 at uniform intervals, a plurality of the first and second spacers 361 and 362 may be included.

As illustrated in FIG. 9, the first and second spacers 361 and 362 may be striped patterned spacers that are extended in a predetermined direction (y-direction). For example, the first spacer 361 may be extended between a row of openings 311' formed in the first electrode 311 and an adjacent row of openings 311' in a predetermined direction (y-direction). Also, the second spacer 362 may be extended between a row of openings 321' formed in the second electrode 321 and an adjacent row of openings 321' in a predetermined direction (y-direction).

A flow path (not shown) having a ruptured form may be formed in the first and second spacers 361 and 362, and flow of the electrolyte 370 may be allowed through the flow path. The structure of the flow path described above is provided in order to prevent reduction in photoelectric conversion efficiency of predetermined areas due to accumulation of the electrolyte 370.

Meanwhile, a sealing member 380 may be disposed along edges of the first and second substrates 310 and 320. By coupling the first and second substrates 310 and 320 by interposing the sealing member 380 therebetween, the first and second accommodation spaces S1 and S2 accommodating the electrolyte 370 may be encapsulated.

It should be understood that the exemplary embodiments described therein should be considered in a descriptive sense only and not for purposes of limitation. Descriptions of features or aspects within each embodiment should typically be considered as available for other similar features or aspects in other embodiments.

### Explanation of Reference numerals designating the Major Elements of the Drawings

110, 310 : first substrate
111, 311 : first electrode
111',311': first electrode and opening of light-absorbing layer
121',321': second electrode and opening of catalyst layer
115, 315: light-absorbing layer
120, 320 : second substrate
121, 321 : second electrode
150, 250, 350 : separator
150', 250', 350': opening
125, 325 : catalyst layer
150a, 350a : first surface of separator
150b, 350b : second surface of separator
161, 361 : first spacer
162, 362 : second spacer
170, 370 : electrolyte
180, 380 : sealing member
S1 : first accommodation space
S2 : second accommodation space
h1 : height of first spacer
h2 : height of second spacer
e: electron

## Claims

1. A photoelectric device comprising:
first and second substrates (110, 120) disposed to face each other;
a separator (150) that is disposed between the first and second substrates; and first and second electrodes (111, 121) that are respectively formed on first and second surfaces of the separator (150a, 150b) wherein a plurality of openings (150') are formed in the separator (150) such that first and second opposite surfaces (150a, 150b) of the separator are fluidally connected to each other.

2. The photoelectric device of claim 1, wherein the openings (150') are formed by patterning the separator (150) or are formed of a plurality of pores formed in a porous separator (350).

3. The photoelectric device of claim 1 or claim 2, wherein openings that are fluidally connected to and aligned with the openings (150') of the separator (150) are formed in the first and second electrodes (111, 121).

4. The photoelectric device of any one of the preceding claims, further comprising:
a light-absorbing layer (115) formed on the first electrode (111); and
a catalyst layer (125) formed on the second electrode (121).

5. The photoelectric device of claim 4, when dependent on claim 3, wherein openings (111', 121') that are fluidally connected to the openings (150') of the separator (150) are formed in the light-absorbing layer (115), and the catalyst layer (125).

6. The photoelectric device of claim 4 or claim 5, wherein the light-absorbing layer (115) is formed on a surface of the first electrode (111) facing the first substrate (110), and the catalyst layer (125) is formed on a surface of the second electrode (121) facing the second substrate (120).

7. The photoelectric device of any one of the preceding claims, wherein an electrolyte (170) is filled between the first and second substrates (110, 120), and the first and second substrates directly contact the electrolyte.

8. The photoelectric device of any one of the preceding claims, wherein the separator (150) is formed of an insulating material so as to prevent a short circuit between the first and second electrodes (111, 121).

9. The photoelectric device of claim 8, wherein the separator either comprises a silicon (Si) oxide or a zirconium (Zr) oxide, or is formed of a non-conductive resin material, optionally polytetrafluoroethylene or a vinyl resin, or a porous inorganic material.

10. The photoelectric device of any one of the preceding claims, further comprising:
a first spacer (161) interposed between the first substrate (110) and the separator (150); and
a second spacer (162) interposed between the second substrate (120) and the separator (150).

11. The photoelectric device of claim 10, wherein the first and second spacers (161, 162) respectively form first and second accommodation spaces (S1, S2), and the first and second accommodation spaces are fluidally connected to each other.

12. The photoelectric device of claim 10 or 11, wherein when the first substrate (110) functions as a light-receiving surface for receiving incident light, the first spacer (161) is formed of a light transparent material.

13. The photoelectric device of any one of the preceding claims, further comprising a sealing member (180) interposed between the first and second substrates (110, 120).

14. The photoelectric device of any one of the preceding claims, wherein the first and second electrodes (111, 121) are formed of metal thin plates.

15. The photoelectric device of claim 14, wherein the first and second electrodes (111, 121) comprise titanium.
